# EUROPÄISCHE PATENTSCHRIFT

(11) **EP 2 148 553 B1**
(45) Veröffentlichungstag und Bekanntmachung des Hinweises auf die Patenterteilung: **02.03.2011**
(21) Anmeldenummer: 08290717.1
(22) Anmeldetag: 21.07.2008
(51) Int. Cl.: H05B 6/76

(54) **Verfahren und Vorrichtung zur Mikrowellen-Leckageüberwachung bei einem Gargerät**
Device and method for microwave leak monitoring for a cooking device
Procédé et dispositif de surveillance de fuites de micro-ondes dans un appareil de cuisson

(43) Veröffentlichungstag der Anmeldung: 27.01.2010
(73) Patentinhaber: Topinox Sarl, 68270 Wittenheim (FR)
(72) Erfinder:
(74) Vertreter: Weber-Bruls, Dorothée

(56) Entgegenhaltungen:
- US-A- 4 354 153
- US-A- 4 565 967
- US-A- 5 138 253

## Beschreibung

### GEBIET DER ERFINDUNG

Die vorliegende Erfindung bezieht sich auf Gargeräte mit Mikrowellenfunktion, bei denen der Austritt von Mikrowellenstrahlung überwacht wird.

### STAND DER TECHNIK

Gargeräte mit einer Mikrowellenerzeugungseinrichtung sind aus dem Stand der Technik vielfältig bekannt. So können beispielsweise Mikrowellenerzeugungseinrichtungen in einem herkömmlichen Umluftgargerät integriert sein. Ebenso sind Gargeräte bekannt, mit denen ausschließlich ein Garen mittels Mikrowellenstrahlung möglich ist.

Ein Gargerät mit Mikrowellenerzeugungseinrichtung ist beispielsweise in der Patentschrift DE 10 2004 059 900 B3 der Anmelderin beschrieben.

Das Erwärmen von Gargut mittels Mikrowellenstrahlung ist ein etabliertes Verfahren und gestattet ein bequemes, schnelles und energiesparendes Auftauen gefrorener Lebensmittel oder ein Garen frischer Lebensmittel. Die direkte Einwirkung von Mikrowellenstrahlung kann allerdings beim Menschen zu Gesundheitsgefährdungen führen. Beim Betrieb von Gargeräten mit Mikrowellenfunktion muss daher stets sichergestellt werden, dass Mikrowellenstrahlung nicht aus dem Inneren des Gargeräts in nennenswertem Umfang entweicht.

Die U S 4,565,967 bezieht sich auf ein Verfahren zur Feststellung von Mikrowcelenleckageeigenschaften eines Mikrowellenofens zur Verwendung bei der Qualitätskontrolle der Herstellung desselben. Es wird dabei ein Gerät, wie ein Roboter, zur Bewegung eines Messfühlers vorgesehen, und zwar mit einem federbelasteten Messfühler oder Sensor. Die Wirkung des Roboters wird mit einem Rechner geregelt, um eine die Bewegung des Messfühlers berücksichtigende, automatische Kompensation der Leckagemessungen zu bewirken. Die Regelung passt automatisch die Geschwindigkeit der Messfühlerbewegung an, um eine verbesserte Genauigkeit bei der Messung der Mikrowellenleckage zu erreichen. Die maximalen Abtastleckagewerte werden zur Bestimmung der Stellen der maximalen Leckage entlang dem Bewegungsweg des Messfühlers ausgegeben.

Die US 5,138,253 offenbart eine Vorrichtung zur Messung von Mikrowellenleckagen, welche die Leistungsdichte der Leckagewellen in Gebieten an der Oberseite, Unterseite, linken Seite und rechten Seite eines Hochfrequenz-Aufwärmgeräts in zwei Schritten vergleicht. Dabei werden die Leckagestellen von einem zentralen Rechner verwendet, um eine der maximalen Leckagestellen auszuwählen. Die Vorrichtung bringt darauf einen der Leistungsdichtedetektoren mittels eines Roboters zu der maximalen Leckagestelle und misst genau die Leistungsdichte der Leckagewellen über ein Zeitintervall, in dem ein Wellenmodewandler des Hochfrequenz-Aufwärmgeräts zumindest eine Umdrehung macht.

Die US 4,354,153 offenbart ein Verfahren zum Ermitteln der maximal möglichen Leistungsdichte von Mikrowellenleckage aus einem Mikrowellenofen im Gebiet der Ofentür. Eine Vielzahl von mikrowellenempfindlichen Antennen wird in eine linearen Anordnung aufgestellt, wobei die Anordnung eine mit zumindest einem Rand des Ofentürumrisses übereinstimmende Konfiguration aufweist. Ein zu testender Ofen wird neben die Anordnung positioniert. Ein Rechner misst sequentiell jedes Antennenbedienelement einer jeden Antenne der Anordnung mittels eines Schalters. Die von jedem Antennenbedienelement sensierte Leistung wird individuell und sequentiell in ein Leistungsmessgerät, welches einen A/D-Wandler umfasst, gekoppelt. Die digitale Information für jedes Antennenbedienelement, inklusive seiner Adresse, wird vom Rechner gespeichert. Bei nachfolgenden Durchgängen wird die Information aktualisiert, um einen Mittelwert zu bilden. Der Rechner wiederholt die Messungen der Antennen, bis eine vorab bestimmte Anzahl von Messungen absolviert ist oder ein Timer den Vorgang unterbricht, was beides Andeutungen dafür sind, dass ein rotierender Ofenreflektor einen Zyklus abgeschlossen hat.

Ein Entweichen von Mikrowellenstrahlung kann verschiedene Ursachen haben. Mikrowellenstrahlen können beispielsweise durch die Türöffnung des Gargeräts entweichen, wenn die Tür während des Betriebs nicht fest verschlossen ist, weil ein Fremdkörper, beispielsweise ein Handtuch, in der Türöffnung eingeklemmt ist. Eine undicht schliessende Türöffnung kann jedoch auch aufgrund von Verschleisserscheinungen auftreten, wenn sich beispielsweise Türscharniere im Laufe der Zeit lockern. Wenn in solchen Fällen die Menge an Leckagestrahlung einen Grenzwert überschreitet, bei dem mögliche Gesundheitsgefährdungen für den Nutzer des Gargeräts nicht ausgeschlossen sind, sollte das Gargerät eine Warnung an den Nutzer ausgeben und alternativ oder zusätzlich den Garbetrieb unterbrechen, um eine weitere Gesundheitsgefährdung auszuschliessen. Zu diesen Zweck können Mikrowellensensoren eingesetzt werden, die beispielsweise in dieGargerätetüröffnung integriert werden, eine eventuelle Leckagestrahlung erfassen und bei Überschreitung eines vorbestimmten Schwellwerts, beispielsweise eines gesetzlichen Grenzwerts, die Mikrowellenstrahlungsquelle abschalten und ein entsprechendes Signal an den Nutzer ausgeben, damit dieser sich um die Behebung der Störung bemühen kann.

Eine Behebung der Störung kann je nach Störungsursache sehr unterschiedliche Massnahmen erfordern. Im ersten Fall eines in der Türöffnung eingeklemmten Fremdkörpers kann der Nutzer die Störung ohne Schwierigkeiten selbst beheben, während im Fall von Verschleisserscheinungen der Einsatz eines Fachmanns oder Kundendienstes notwendig werden kann.

Es besteht daher Bedarf an einer Mikrowellen-Leckageüberwachung, die Rückschlüsse auf die Störungsursache zulässt und eine schnelle, ursachenspezifische Störungsbeseitigung ermöglicht.

Eine solche Mikrowellen-Leckageüberwachung wird durch das erfindungsgemässe Verfahren mit den Merkmalen von Anspruch 1 bereitgestellt. Anspruch 12 bezieht sich auf ein erfmdungsgemässes Gargerät mit einer entsprechenden Vorrichtung zur Mikrowellen-Leckageüberwachung. Die Unteransprüche betreffen vorteilhafte Ausführungsformen.

Bei dem erfindungsgemässen Verfahren zur Mikrowellen-Leckageüberwachung bei einem Gargerät wird eine Mikrowellen-Leckagestrahlung mittels einer Mikrowellen-Sensoreinrichtung erfasst, der zeitliche Verlauf der erfassten Mikrowellenstrahlung für ein erstes Zeitintervall mittels einer mit der Mikrowellen-Sensoreinrichtung verbundenen Speichereinrichtung gespeichert und zumindest ein Teil der gespeicherten Mikrowellenstrahlungswerte ausgewertet und/oder zur Auswertung ausgegeben. Dabei kann es sich bei dem ersten Zeitintervall beispielsweise um ein vorbestimmtes Zeitintervall von mindestens einer Woche, typischerweise von mehreren Wochen oder Monaten handeln.

Aus dem zeitlichen Verlauf der erfassten Mikrowellenstrahlung kann der Nutzer oder ein Kundendienst im Fall einer aufgetretenen Störung Rückschlüsse auf die Ursache der Mikrowellen-Leckage ziehen. Zudem können aus den erfassten und gespeicherten Mikrowellenstrahlungswerten im Zuge einer Routine-Überprüfung schon vor dem Auftreten einer Grenzwertüberschreitung mögliche Strahlungslecks und Fehlerquellen erkannt und zu erwartende Probleme frühzeitig diagnostiziert werden. Auf diese Weise kann überraschenden Betriebsausfällen entgegengewirkt werden.

In einer bevorzugten Ausführungsform wird die Mikrowellen-Leckagestrahlung im Bereich einer oder mehrerer Öffnungen des Gargeräts erfasst.

In einer weiteren bevorzugten Ausführungsform wird die Mikrowellen-Leckagestrahlung an mehreren Positionen unabhängig voneinander erfasst.

Dadurch ergibt sich der Vorteil, dass mehrere Positionen an oder in der Nähe eines Gargeräts, an denen erfahrungsgemäß eine Mikrowellen-Leckage zu erwarten ist, gleichzeitig und unabhängig voneinander überwacht werden können. Zudem bietet die unabhängige Überwachung an mehreren Positionen Sicherheit gegen eventuelle Ausfälle und Fehlfunktionen der Überwachungseinrichtung.

In einer weiteren bevorzugten Ausführungsform wird ein Mittelwert und/oder ein Effektivwert mehrerer erfasster Mikrowellenstrahlungswerte gespeichert.

Ein Effektivwert kann aus den erfassten Strahlungswerten beispielsweise unter Einbeziehung der räumlichen Geometrie des Gargeräts sowie der Positionen der Sensoreinrichtungen errechnet werden, um Aufschluss über die zu erwartenden Leckage-Strahlung an solchen Positionen an dem Gargerät oder in der Nähe des Gargeräts zu geben, an denen keine Sensoreinrichtungen vorgesehen sind oder angebracht werden können. Dadurch wird mit einer verhältnismäßig geringen Anzahl an Sensoreinrichtungen eine effektive Überwachung der Mikrowellen-Leckagestrahlung ermöglicht.

In einer vorteilhaften Ausfübrungsform erfolgt das Erfassen und/oder Speichern der Mikrowellen-Leckagestrahlung in vorbestimmten regelmäßigen zeitlichen Abständen.

Durch geeignete Wahl des Messzeitintervalls lässt sich die Leckage-Überwachung an die Nutzungsbedingungen des Gargeräts anpassen.

In einer alternativen Ausführungsform erfolgt das Erfassen und/oder Speichern dagegen in unregelmäßigen zeitlichen Abständen, die ein vorbestimmtes zweites Zeitintervall nicht überschreiten.

Indem die Überwachung in zeitlich unregelmäßigen Abständen erfolgt, die beispielsweise mit Hilfe eines Zufallsgenerators innerhalb des vorbestimmten zweiten Zeitintervalls gewählt werden können, wird verhindert, dass die Überwachung versehentlich mit Perioden niedriger Mikrowellen-Leckage synchronisiert ist und zwischen den Überwachungszeitpunkten auftretende Schwellwertüberschreitungen unbeachtet bleiben. Ebenso kann durch zeitlich unregelmäßige Überwachung verhindert werden, dass die Überwachungszeitpunkte versehentlich Perioden besonders hoher Mikrowellen-Leckagestrahlung entsprechen und demzufolge eine übermäßig hohe Leckagestrahlung gespeichert und angezeigt wird.

In einer weiteren vorteilhaften Ausführungsform der Erfindung werden die Mikrowellenstrahlungswerte in regelmäßigen zeitlichen Abständen und/oder auf Anforderung eines Nutzers ausgegeben.

In einer bevorzugten Ausführungsform umfasst die Auswertung das Prognostizieren des zukünftigen zeitlichen Verlaufs der erfassten Mikrowellenstrahlung auf der Grundlage des gespeicherten zeitlichen Verlaufs der erfassten Mikrowellenstrahlung, das Vergleichen des prognostizierten zeitlichen Verlaufs der erfassten Mikrowellenstrahlung mit einem vorbestimmten ersten Schwellwert sowie das Signalisieren einer auf der Grundlage des prognostizierten Verlauf erwarteten Überschreitung des ersten Schwellwerts. Dazu kann irgendein geeignetes Signal ausgegeben werden, das mit der erwarteten Überschreitung assoziiert ist.

Indem aus dem gespeicherten zeitlichen Verlauf der erfassten Mikrowellenstrahlung eine Vorhersage auf den zukünftig zu erwartenden zeitlichen Verlauf der Leckagestrahlung erstellt wird, lassen sich zukünftig zu erwartende Überschreitungen eines festgelegten Schwellwerts schon frühzeitig erkennen, insbesondere bei einer auf fortschreitendem Verschleiß von Komponenten des Gargeräts beruhenden Mikrowellen-Leckage. Indem eine auf der Grundlage des prognostizierten Verlaufs erwartete Überschreitung des ersten Schwellwerts signalisiert wird, kann der Nutzer Maßnahmen zur Entstörung einleiten, bevor eine Schwellwertüberschreitung eintritt. Dadurch wird eine schnelle vorauseilende Fehlerbeseitigung möglich, und es werden Ausfallzeiten verkürzt und ein reibungsloser Betrieb des Gargeräts sichergestellt.

In einer vorteilhaften Ausführungsform wird der zukünftige zeitliche Verlauf der erfassten Mikrowellenstrahlung mittels einer Extrapolation oder Trend- bzw. Zeitreihenanalyse prognostiziert. Auf diese Weise lässt sich zuverlässig der Zeitpunkt einer zu erwartenden Schwellwertüberschreitung ermitteln.

In einer weiteren vorteilhaften Ausführungsform wird ein Signal ausgegeben, wenn der prognostizierte zeitliche Verlauf eine Überschreitung des ersten Schwellwerts innerhalb eines vorbestimmten dritten Zeitintervalls erwarten lässt.

Indem das dritte Zeitintervall geeignet gewählt wird, wird dem Nutzer ausreichend Zeit zur Behebung der Störung oder zur Anforderung eines Kundendienstes gegeben, bevor es zu einer möglicherweise kritischen Überschreitung des ersten Schwellwerts kommt. Die frühzeitige Benachrichtigung des Nutzers bzw. Kundendienstes ermöglicht eine rechtzeitige Störungsbehebung, so dass Geräteausfälle vermieden werden. Dadurch wird ein weitgehend unterbrechungsfreier Gargerätebetrieb sichergestellt.

Das ausgegebene Signal repräsentiert in einer bevorzugten Ausführungsform den aktuellen Wert der erfassten Mikrowellenstrahlung und/oder den gespeicherten zeitlichen Verlauf der erfassten Mikrowellenstrahlung und/oder den prognostizierten zeitlichen Verlauf der Mikrowellenstrahlung und/oder den prognostizierten Zeitpunkt der Überschreitung des ersten Schwellwerts.

Das Signal kann in einer bevorzugten Ausführungsform lokal an einen Nutzer, beispielsweise über ein mit dem Gargerät verbundenes Anzeigegerät und/oder an eine mit dem Gargerät verbundene Steuereinheit ausgegeben werden. Dadurch ergibt sich der Vorteil, dass der Nutzer über eine drohende Schwellwertüberschreitung informiert wird. Bei Ausgabe des Signalwerts an eine mit dem Gargerät verbundene Steuereinheit lässt sich überdies gewährleisten, dass der Mikrowellenbetrieb automatisch unterbunden wird, sobald eine Schwellwertüberschreitung eingetreten ist oder unmittelbar bevorsteht. Auf diese Weise lässt sich wirkungsvoll verhindern, dass Mikrowellenstrahlung in für den Nutzer möglicherweise Gesundheitsgefährdendem Umfang aus dem Gargerät entweicht.

Ebenso kann das Signal alternativ oder zusätzlich mittels einer Datenverbindung an eine entfernte Überwachungseinrichtung übermittelt werden. Auf diese Weise kann beispielsweise ein Kundendienst in die Lage versetzt werden, die Mikrowellen-Leckage aus der Ferne zu überwachen und bei drohender Überschreitung eines Schwellwerts frühzeitig geeignete Gegenmaßnahmen einzuleiten.

In einer weiteren vorteilhaften Ausführungsform wird ein Signal nur dann ausgegeben, wenn der aktuell prognostizierte zeitliche Verlauf den ersten Schwellwert nicht nur einmaling, sondern für mindestens die Dauer eines vorbestimmten vierten Zeitintervalls überschreitet.

Dadurch kann gewährleistet werden, dass lediglich vorübergehende und durch den Nutzer ohne Schwierigkeiten selbst zu behebende Schwellwertüberschreitungen, wie sie beispielsweise aus dem Einklemmen eines Fremdkörpers in der Türöffnung des Gargeräts resultieren können, selbständig erkannt werden und nicht als dauerhaftes Problem mißinterpretiert werden. Denn obwohl derartige Störungen bei manchen Extrapolationsalgorithmen zu dem Ergebnis führen könnten, dass eine Schwellwertüberschreitung bevorsteht, ist dieses Prognoseergebnis bei einem nur kurzfristigen, isolierten Anstieg der Leckagestrahlung nur von kurzer Dauer und würde daher bei dieser Weiterbildung nicht berücksichtigt. Somit kann einfach und wirkungsvoll zwischen vorübergehenden kurzfristigen Störungen einerseits und langfristigen Verschleißerscheinungen andererseits unterschieden werden. Insbesondere kann auf diese Weise verhindert werden, dass ein Kundendienst unnötigerweise informiert wird. Dadurch lassen sich bei Gewährleistung eines reibungslosen Betriebs des Gargeräts die Wartungs- und Servicekosten gering halten.

In einer weiteren vorteilhaften Ausführungsform wird ein Signal nur dann ausgegeben, wenn mehrere auf der Grundlage räumlich getrennter Sensoreinrichtungen prognostizierte Zeitverläufe der Mikrowellenstrahlung eine Überschreitung des ersten Schwellwerts vorhersagen. Auf diese Weise lässt sich ausschließen, dass die Fehlfunktion eines Sensors eine unnötige Alarmierung des Nutzers oder Kundendienstes verursacht.

In einer weiteren vorteilhaften Ausführungsform wird ein Signal nur dann ausgegeben, wenn mehrere auf der Grundlage von zu unterschiedlichen Zeitpunkten erfassten Mikrowellenstrahlungswerten prognostizierte Zeitverläufe der Mikrowellenstrahlung eine Überschreitung des ersten Schwellwerts vorhersagen. Bei den unterschiedlichen Zeitpunkten kann es sich insbesondere um mehrere aufeinander folgende Messzeitpunkte handeln, d.h. der Prognose werden unterschiedliche Datensätze aus den gespeicherten Leckagestrahlungsdaten zugrunde gelegt.

Indem ein Signal nur ausgegeben wird, wenn auf der Basis unterschiedlicher Datensätze erstellte Prognosen des zukünftigen Strahlungswertverlaufs übereinstimmend einer Überschreitung des Schwellwerts vorhersagen, werden kurzfristige Schwankungen der Leckage-Strahlung sowie Fluktuationen im Betrieb der Sensoren wirkungsvoll ausgefiltert und verhindert, dass beispielsweise eine nur vorübergehende Störung, wie etwa ein in der Türöffnung eingeklemmter Fremdkörper, als Verschleißstörung missinterpretiert und unnötigerweise ein Kundendienst in Anspruch genommen wird.

In einer weiteren vorteilhaften Ausführungsform wird ein Signal ausgegeben, wenn der aktuell erfasste Mikrowellenstrahlungswert einen zweiten Schwellwert überschreitet, der höher als der erste Schwellwert liegt.

Bei dem zweiten Schwellwert kann es sich beispielsweise um einen Wert der Mikrowellenstrahlung handeln, der unter keinen Umständen überschritten werden sollte und deren Überschreitung mit erheblicher Wahrscheinlichkeit eine Gesundheitsgefährdung eines Nutzers zur Folge hätte. Indem bei Überschreitung eines solchen zweiten Schwellwerts ein Signal ausgegeben wird, kann der Nutzer gewarnt werden und der Mikrowellen-Garbetrieb unverzüglich unterbrochen werden, ohne dass die Möglichkeit von Konsistenzüberprüfungen wesentlich eingeschränkt wird.

Eine Vorrichtung zur Mikrowellen-Leckageüberwachung in einem erfindungsgemäßen Gargerät umfasst eine Mikrowellen-Sensoreinrichtung mit zumindest einer Sensoreinheit, die zum Erfassen einer Mikrowellen-Leckagestrahlung geeignet ist, eine Speichereinrichtung, die mit der Mikrowellen-Sensoreinrichtung verbunden und zum Speichern des zeitlichen Verlaufs der von der Mikrowellen-Sensoreinrichtung erfassten Mikrowellenstrahlung geeignet ist, sowie einer Auswertungseinrichtung, die mit der Speichereinrichtung und/oder der Mikrowellen-Sensoreinrichtung verbunden und dazu geeignet ist, zumindest einen Teil der in der Speichereinrichtung gespeicherten Mikrowellenstrahlungswerte auszuwerten und/oder zur Auswertung auszugeben.

Die Auswertungseinrichtung umfasst in einer bevorzugten Ausführungsform eine Ausgabeeinheit, die zum Ausgeben des gespeicherten zeitlichen Verlaufs der erfassten Mikrowellenstrahlung in regelmäßigen zeitlichen Abständen und/oder auf Anforderung eines Nutzers geeignet ist.

In einer weiteren vorteilhaften Ausführungsform umfasst die Auswertungseinrichtung eine Datenverarbeitungseinrichtung, die dazu geeignet ist, auf der Grundlage der in der Speichereinrichtung gespeicherten Mikrowellenstrahlungswerte einen prognostizierten zeitlichen Verlauf der Mikrowellenstrahlung zu errechnen, den prognostizierten zeitlichen Verlauf mit einem vorbestimmten ersten Schwellwert zu vergleichen und eine auf der Grundlage des prognostizierten Verlaufs erwartete Überschreitung des vorbestimmten ersten Schwellwerts zu signalisieren.

In einer weiteren vorteilhaften Ausführungsform umfasst die erfindungsgemäße Vorrichtung zusätzlich eine mit der Datenverarbeitungseinrichtung verbundene Datenübertragungseinrichtung zum Übertragen eines Signals der Datenverarbeitungseinrichtung an eine vom Gargerät räumlich entfernte Überwachungseinrichtung.

Die Erfindung bezieht sich gleichfalls auf ein Gargerät mit einer Vorrichtung zur Mikrowellen-Leckageauswertung in einer der vorstehend beschriebenen Ausführungsformen oder in einer Kombination solcher Ausführungsformen, wobei die Sensoreinheit in oder an einer Geräteöffnung des Gargeräts angeordnet ist. In einer vorteilhaften Ausführungsform kann es sich bei der Geräteöffnung um eine Tür, einen Abfluss, eine Lampenfassung, eine Dampfzuführöffnung, eine Zuluftöffnung und/oder eine Abluftöffnung handeln. Es können auch eine oder mehrere Sensoreinheiten in einer Tür oder einem Deckel des Gargerätes vorgesehen sein. In einer vorteilhaften Weiterbildung ist mindestens eine Sensoreinheit in einem Gehäuseabschnitt angeordnet, in dem elektrische Bauteile oder -gruppen angeordnet sind und der auch als "Installationsraum" bezeichnet wird. Dadurch kann detektiert werden, wenn Mikrowellenstrahlung, beispielsweise aufgrund von Toleranzen bei der Montage von Magnetrons, in den Installationsraum abgegeben wird. Diese Leckage in den Installationsraum stellt zwar keine Gesundheitsgefahr dar, verschlechtert aber den Wirkungsgrad des Gerätes. Außerdem können weitere elektronische Baugruppen im Installationsraum durch die Mikrowellenstrahlung beschädigt werden.

Das Gargerät umfasst in einer weiteren bevorzugten Ausführungsform eine Steuereinheit, die dazu eingerichtet ist, in Abhängigkeit eines Signals von der Datenverarbeitungseinrichtung den Betrieb des Gargeräts zu unterbrechen.

Dadurch lässt sich sicherstellen, dass bei einer zu befürchtenden Gesundheitsgefährdung durch austretende Mikrowellenstrahlung der Garbetrieb selbsttätig und schnell unterbunden wird.

Das erfindungsgemäße Verfahren zur Mikrowellen-Leckageüberwachung sowie das entsprechende erfindungsgemäße Gargerät erlauben eine zuverlässige Unterscheidung von kurzfristigen, durch den Nutzer selbständig zu behebenden Störungen einerseits und zu erwartenden dauerhaften Schwellwertüberschreitungen aufgrund langfristiger Verschleißerscheinungen andererseits und ermöglichen auf diese Weise eine effiziente, an die Störungsursache angepasste Wartung. Dabei ist stets sichergestellt, dass eventuelle gesundheitsgefährdende Leckagestrahlung erkannt bzw. frühzeitig prognostiziert wird.

Die Merkmale und Vorteile des erfindungsgemäßen Verfahrens sowie des erfindungsgemäßen Gargeräts mit einer Vorrichtung zur Mikrowellen-Leckageüberwachung sind am besten aus der nachfolgenden detaillierten Beschreibung einer bevorzugten Ausführungsform anhand der beigefügten Zeichnungen ersichtlich, in denen:
- Fig. 1: den schematischen Aufbau eines Gargeräts mit Mikrowellenfunktion und einer Vorrichtung zur Mikrowellen-Leckageüberwachung gemäß der vorliegenden Erfindung zeigt;
- Fig. 2: den zeitlichen Verlauf der erfassten Mikrowellen-Leckagestrahlung bei zu erwartender dauerhafter Überschreitung eines Schwellwerts zeigt;
- Fig. 3: beispielhaft den zeitlichen Verlauf der erfassten Mikrowellen-Leckagestrahlung bei kurzfristiger Überschreitung des Schwellwerts; und
- Fig. 4: eine schematische Darstellung einer Sensoreinheit zeigt.

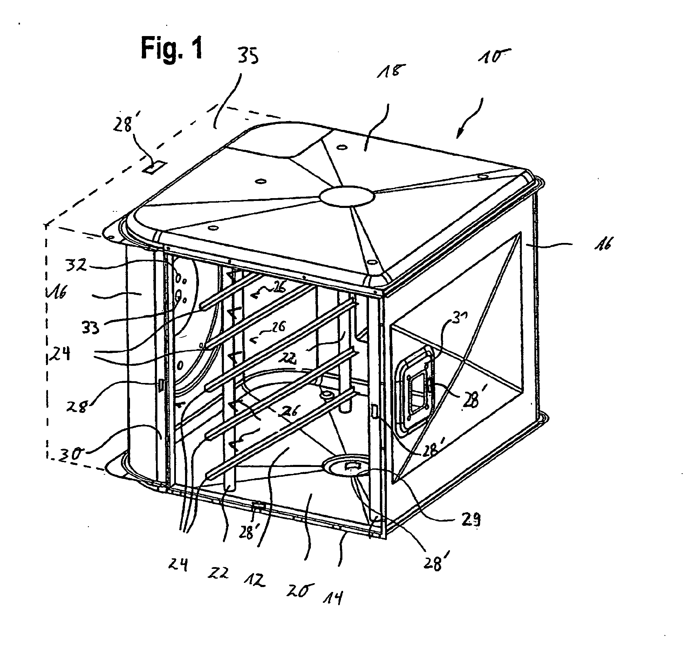

Fig. 1 ist zu überwiegenden Teilen der Patentschrift DE 10 2004 059 900 B3 der Anmelderin entnommen und zeigt ein Gargerät mit Mikrowellenfunktion 10 mit einer erfindungsgemäßen Vorrichtung zur Mikrowellen-Leckageüberwachung. Das Gargerät 10 weist einen Garraum 12 auf, der von einer Bodenfläche 14, Seitenwänden 16 und einer Abdeckung 18 umgrenzt wird, wobei in einer der Seitenwände 16 eine Gargeräteöffnung 20 ausgebildet ist, durch die Gargut in den Garraum 12 eingebracht und aus ihm entnommen werden kann und die durch eine (nicht gezeigte) Gargerätetür dicht verschlossen werden kann. Innerhalb des Garraums 12 sind vier Träger 22 angeordnet, von denen in Fig. 1 drei Träger 22 zu erkennen sind. An den Trägern 22 sind Einschubleisten 24 angeordnet, in die Garbehälter (nicht gezeigt) eingeschoben und auf diese Weise im Garraum 12 positioniert werden können. Die Träger 22 sind als Koaxialleiter ausgeführt und weisen mehrere Auskopplungsstellen 26 auf, über die in einer Mikrowellenquelle (nicht gezeigt) erzeugte Mikrowellenstrahlung in den Garraum 12 abgegeben werden kann. Weitere Auskopplungsstellen 26 sind an der linken Seitenwand 16 vorgesehen.

Das Gargerät mit Mikrowellenfunktion 10 ist in der DE 10 2004 059 900 B3 in weiteren Einzelheiten beschrieben.

Das in Fig. 1 gezeigte Gargerät weist zudem einen Mikrowellensensor 28 auf, der in einen Türbeschlag 30 der Gargeräteöffnung 20 integriert ist. Mikrowellensensoren 28' können alternativ oder zusätzlich auch beidseitig der Türöffnung, in einer Lampenfassung 31, in einer Abluft- oder Zuluftöffnung 32 oder einer Dampfzuführöffnung 33 des Garraums 12 oder einer in die Bodenfläche 14 eingelassenen Abflussöffnung 29 angebracht sein. Ferner könnte ein weiterer Mikrowellensensor 28'in einem Installationsraum 35 angeordnet sein, der in Fig. 1 lediglich schematisch angedeutet ist. Der Installationsraum ist ein Gehäuseabschnitt, in dem elektronische Baugruppen, beispielsweise eine Pumpe, ein Motor für ein Gebläse, ein Dampferzeuger, Magnetrons zum Erzeugen der Mikrowellen etc. untergebracht sind. Wenn die Magnetrons (nicht gezeigt) nach einer Wartung nicht optimal justiert sind, kann es passieren, dass die Mikrowellen nicht vollständig in den Garraum 12 geleitet werden, sondern ein Teil davon in den Installationsraum 35 gestrahlt wird. Diese Mikrowellen sind zwar nicht gesundheitsschädlich für den Nutzer, könnten jedoch zur Beschädigung weiterer elektronischer Bauteile führen und stellen in jedem Fall eine Verschlechterung des Wirkungsgrades der Mikrowellenfunktion dar. Aus diesem Grund ist es auch vorteilhaft, die Mikrowellenstrahlung im Montageraum zu überwachen.

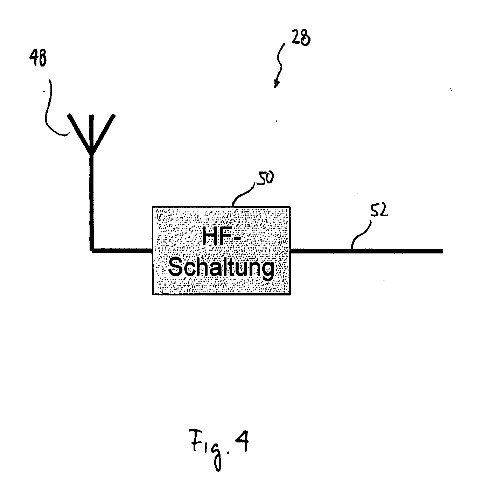

Bei dem Mikrowellensensor 28 kann es sich beispielsweise um einen in einen integrierten Schaltkreis eingebetteten Sensorschaltkreis handeln. Ein Mikrowellensensor 28 ist in Fig. 4 schematisch dargestellt. Er umfasst eine Antenne 48, mit der die Mikrowellenstrahlung empfangen wird, und eine HF-Schaltung 50, die das empfangene Signal verarbeitet und ein Signal an einen Ausgang 52 ausgibt, welches die Intensität der empfangenen Strahlung repräsentiert. Das Ausgabesignal kann dabei beispielsweise ein Gleichspannungssignal sein.

Der oder die Mikrowellensensoren 28 erfassen die von dem Gargerät ausgehende Mikrowellen-Leckagestrahlung und sind über eine Datenleitung mit einer (nicht gezeigten) Speichereinrichtung verbunden, in der der zeitliche Verlauf der von den Mikrowellensensoren 28 erfassten Mikrowellenstrahlung gespeichert wird. Die Speichereinrichtung kann jede aus dem Stand der Technik bekannte Speichereinheit mit bevorzugt nichtflüchtigem Speicher umfassen. Die Speichereinrichtung ist ihrerseits über eine Datenleitung mit einer (nicht gezeigten) Auswertungseinrichtung verbunden, in der die in der Speichereinrichtung gespeicherten Mikrowellenstrahlungswerte ausgewertet und/oder zur Auswertung ausgegeben werden. Die Ausgabe kann beispielsweise an einer Anzeigeeinrichtung (nicht gezeigt) am Bedienelement des Gargeräts 10 erfolgen, beispielsweise an ein LCD-Display.

In der beschriebenen Ausführungsform enthält die Auswertungseinrichtung insbesondere eine Datenverarbeitungseinrichtung, die auf der Grundlage der in der Speichereinrichtung gespeicherten Mikrowellenstrahlungswerte einen prognostizierten zeitlichen Verlauf der Mikrowellenstrahlung errechnet, den prognostizierten zeitlichen Verlauf mit einem vorbestimmten Schwellwert vergleicht und eine auf der Grundlage des prognostizierten Verlaufs erwartete Überschreitung des Schwellwerts signalisiert. Der Schwellwert kann in Abhängigkeit der gesetzlichen Vorschriften gewählt und über eine mit der Datenverarbeitungseinrichtung verbundene Eingabeeinheit, beispielsweise ein Tastenfeld an der Bedieneinheit des Gargerätes, in die Datenverarbeitungseinrichtung eingegeben werden oder vorprogrammiert sein. In dem gezeigten Beispiel liegt der Schwellwert bei 5 mW/cm². Bei Überschreitung oder drohender Überschreitung des Schwellwerts wird das Signal an die Bedieneinheit des Gargeräts 10 ausgegeben und alternativ oder zusätzlich über einen Datenübertragungsleitung (nicht gezeigt) ein Kundendienst informiert. Bei Überschreitung des Schwellwerts kann darüber hinaus die Datenverarbeitungseinrichtung ein Signal an die Steuereinrichtung des erfindungsgemäßen Gargeräts 10 übermitteln, woraufhin die Steuereinheit den Mikrowellenbetrieb des Gargeräts 10 unterbricht, um einen mögliche Gesundheitsgefährdung des Nutzers des Gargeräts 10 zu unterbinden.

In einer alternativen Ausführungsform werden zwei Schwellwerte verwendet, nämlich ein niedrigerer Schwellwert von beispielsweise 3 mW/cm² und ein höherer Schwellwert von 5 mW/cm². Der höhere Schwellwert entspricht dabei dem Wert, der nach Norm maximal zulässig ist. Der niedrigere Schwellwert dient als Vorwarnschwelle. Wenn diese überschritten wird, werden die Prüfzeitintervalle verkürzt, um die Leckagestrahlung in kürzeren Zeiträumen zu überwachen.

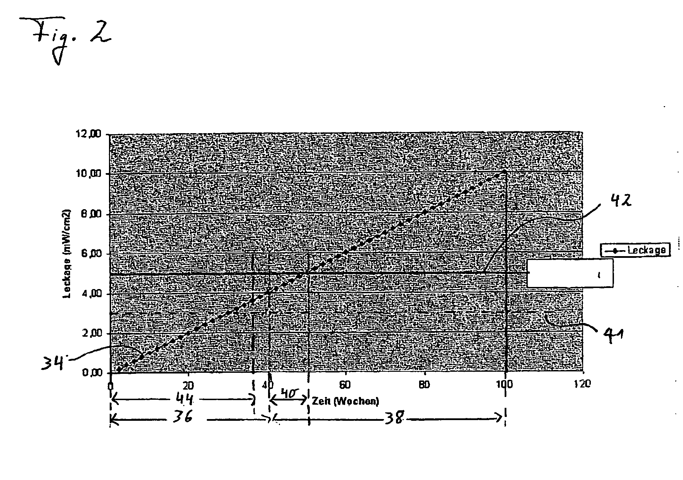

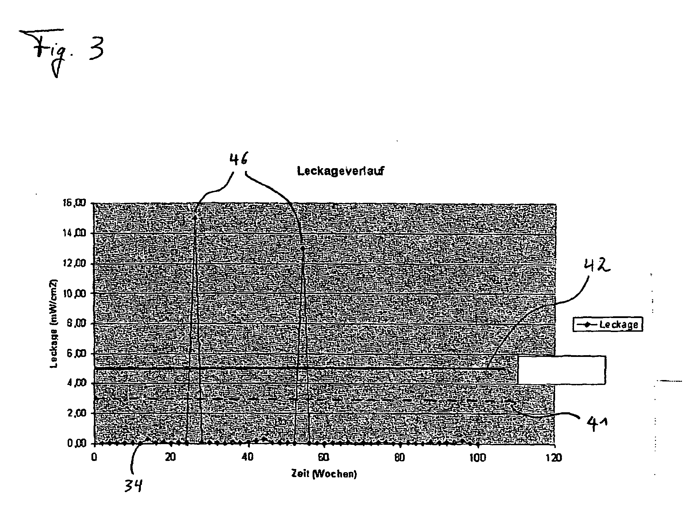

Die Wirkungsweise der Datenverarbeitungseinrichtung und insbesondere das erfindungsgemäße Verfahren zur Prognose des zukünftigen Verlaufs der Mikrowellen-Leckagestrahlung sowie zur Signalisierung einer zu erwartenden Schwellwertüberschreitung an den Nutzer und/oder einen Kundendienst werden nachfolgend mit Bezug auf die Figuren 2 und 3 genauer beschrieben.

Fig. 2 zeigt den zeitlichen Verlauf 34 der von dem Mikrowellensensor 28 erfassten und in der Speichereinrichtung gespeicherten Mikrowellen-Leckagestrahlung für die Dauer eines ersten Zeitintervalls 36, das im gezeigten Beispiel 40 Wochen beträgt. Wie aus Fig. 1 zu entnehmen ist, werden die Strahlungswerte innerhalb des Intervalls 36 in regelmäßigen Zeitabständen erfasst, wobei jede Raute entlang der Messkurve 34 einem Messpunkt entspricht. Die Messintervalle können sowohl vorprogrammiert als auch über die Bedieneinheit des Gargerätes wähl- und einstellbar sein. Der zeitliche Verlauf 34 zeigt innerhalb des Zeitintervalls 36 einen linearen Anstieg der in mW/cm² gemessenen Mikrowellen-Leckagestrahlung am Ort des Mikrowellensensors 28. Ein solcher linearer Anstieg der Leckagestrahlung kann sich typischerweise aufgrund von Verschleißerscheinungen ergeben, wenn sich beispielsweise die Gargerätetür des Garraums 12 im Laufe der Zeit aus ihrer festen Position lockert und deswegen der Türspalt fortwährend größer wird, so dass zunehmend Mikrowellenstrahlung den Garraum 12 verlassen kann. Ein ähnlicher Verlauf der Mikrowellen-Leckagestrahlung ergibt sich, wenn sich beim Betrieb des Gargeräts 10 entstehende Verschmutzungen an den Dichtungen der Gargerätetür ablagern und zu Undichtigkeiten führen. Die Alterung von Bauteilen, beispielsweise von Scharnieren oder Dichtungen der Gargerätetür, kann gleichfalls zu einem linearen Anstieg der Leckagestrahlung mit der Zeit am Ort des Mikrowellensensors 28 fiihren, wie er in Fig. 2 gezeigt ist. In Abhängigkeit von der Ursache der Störung oder des Verschleißes kann der Leckageverlauf auch parabelförmig, exponentiell oder logarithmisch verlaufen oder eine andere Kurvenform aufweisen.

Mit Hilfe des erfindungsgemäßen Verfahrens kann aus den innerhalb des ersten Zeitintervalls 36 ermittelten und gespeicherten Daten der Mikrowellen-Leckagestrahlung der zukünftige Verlauf der Leckagestrahlung für ein Zeitintervall 38, das beispielsweise die nachfolgenden 60 Wochen umfasst, prognostiziert werden. Die Prognose des zukünftigen Leckageverlaufs kann auf einer Trendanalyse oder Zeitreihenanalyse oder sonstigen geeigneten Extrapolationsverfahren beruhen. Für den Fall des in Fig. 2 gezeigten linearen Leckageverlaufs kann eine Extrapolation beispielsweise durch Auswertung der Steigung des Funktionsverlaufs 34 im Zeitintervall 36 und lineare Fortschreibung in das PrognoseZeitintervall 38 erfolgen. Die Extrapolation kann auch auf einer Wahrscheinlichkeitsrechnung beruhen.

Wie in Fig. 2 gezeigt, ergibt die in dieser Weise durchgeführte Prognose des zukünftigen Leckageverlaufs, dass nach Ablauf eines dritten Zeitintervalls 40 von 10 Wochen der vorbestimmte erste Schwellwert 42, der in Fig. 1 durch eine horizontale Linie beim Leckagewert von 5 mW/cm² veranschaulicht ist, vermutlich überschritten wird.

Diese Prognose kann beispielsweise dadurch bekräftigt werden, dass eine zweite Extrapolation auf Grundlage der innerhalb des ersten Zeitintervalls 36 von einer zweiten Sensoreinheit, die von dem ersten Mikrowellensensor 28 unabhängig ist, erfassten Leckagestrahlung durchgerührt wird. Auf diese Weise lässt sich die Gefahr eines durch eine defekte Sensoreinrichtung hervorgerufenen Fehlalarms verringern.

Die Prognose kann auch dadurch überprüft werden, dass der Zeitpunkt der Überschreitung des ersten Schwellwerts 42 zusätzlich auf der Grundlage der von dem Mikrowellensensor 28 während eines Kontrollintervalls 44 erfassten Leckagestrahlungswerte errechnet wird und ein Alarm nur dann signalisiert wird, wenn beide Prognosen unabhängig voneinander übereinstimmende oder nahezu übereinstimmende Ergebnisse liefern. Bei dem in Fig. 2 veranschaulichten Beispiel handelt es sich bei dem Kontrollintervall 44 um ein im Vergleich zum ersten Zeitintervall 36 geringfügig verkürztes Zeitintervall.

Ebenso kann der Zeitpunkt der Überschreitung des ersten Schwellwerts 42 auch durch eine Prognose, die während eines auf das erste Zeitintervall 36 folgenden dritten Zeitintervalls 40 erfasste Leckagestrahlungswerte einbezieht, bestätigt werden, bevor eine drohende Überschreitung des ersten Schwellwerts signalisiert wird.

Durch diese Konsistenz- und Überprüfungsverfahren lässt sich die Gefahr eines Fehlalarms, wie er beispielsweise durch kurzfristige Schwankungen der Leckagestrahlung hervorgerufen werden kann, wirkungsvoll vermindern.

Eine solche kurzfristige Schwankung kann sich beispielsweise ergeben, wenn ein Fremdkörper, beispielsweise ein Handtuch, versehentlich in der den Garraum 12 verschließenden Gerätetür des Gargeräts 10 eingeklemmt wird und das Gargerät 10 in diesem Zustand in Betrieb genommen wird. Ein entsprechender zeitlicher Verlauf der vom Mikrowellensensor 28 erfassten Leckagestrahlung ist in Fig. 3 gezeigt.

Der Leckagewert von 5 mW/cm² des Schwellwertes 42 entspricht dem zulässigen Grenzwert. In einer Weiterbildung kann ein zweiter, niedrigerer Schwellwert 41 vorgesehen sein, der in Fig. 2 und 3 ebenfalls eingezeichnet ist. Der niedrigere Schwellwert 41 dient als Vorwarnschwelle. Sobald er überschritten wird, wird das Zeitintervall der Überprüfung der Leckagestrahlung verkürzt, um die Leckage enger zu überwachen.

Bei Abwesenheit von Verschleißerscheinungen oder sonstigen dauerhaften Störquellen liegen die von dem Mikrowellensensor 28 erfassten Leckagestrahlungswerte 34 im Gegensatz zu dem in Fig. 2 gezeigten Leckageverlauf dauerhaft auf einem konstant niedrigen Niveau. Der erste Schwellwert 42 wird lediglich kurzfristig überschritten, während das Handtuch versehentlich in der Tür eingeklemmt ist. Sobald der Nutzer seinen Fehler bemerkt und das Handtuch entfernt, fällt der erfasste Wert der Leckagestrahlung wieder auf das niedrige Ausgangsniveau zurück. Eine solche kurzfristige Überschreitung des ersten Schwellwerts 42 zeigt sich im Leckageverlauf 34 durch isolierte, zeitlich eng begrenzte Ausschläge. Die Fig. 3 zeigt zwei solche Leckagespitzen 46.

Die obenstehend im Zusammenhang mit der Fig. 2 beschriebenen Konsistenz- und Überprüfungsverfahren stellen sicher, dass kurzfristige Überschreitung des ersten Schwellwerts 42, wie sie sich beispielsweise durch Einklemmen eines Fremdkörpers in der Gargerätetür ergeben können und in Fig. 3 durch Leckagespitzen veranschaulicht sind, bei einer Extrapolation nicht als dauerhafte Überschreitung des ersten Schwellewerts mißinterpretiert werden.

Das obenstehend beschriebene erfindungsgemäße Prognoseverfahren gestattet auf diese Weise die Unterscheidung zwischen zu erwartenden dauerhaften Überschreitungen des ersten Schwellwerts 42, die beispielsweise durch Verschleißerscheinungen hervorgerufen sein können und in Fig. 2 illustriert sind, und lediglich kurzfristigen oder einmaligen Überschreitungen des ersten Schwellwerts 42, wie sie sich beispielsweise beim Einklemmen eines Fremdkörpers in der Türöffnung ergeben und in Fig. 3 veranschaulicht sind.

Liegt eine nur kurzfristige Überschreitung des ersten Schwellwerts 42 vor, gibt die Datenverarbeitungseinrichtung lediglich ein die momentane Überschreitung anzeigendes Signal an die Bedieneinheit des Gargeräts 10 aus. Der Nutzer kann im Allgemeinen in einem solchen Fall die Störung selbst beheben, im beschriebenen Beispiel also den Fremdkörper aus der Türöffnung entfernen.

Sofern keine dauerhafte Überschreitung des ersten Schwellwerts 42 prognostiziert wird, ist eine Benachrichtigung des Kundendienstes entbehrlich. Der Betrieb des Gargeräts 10 ist lediglich kurzfristig während des Auftretens der Leckagespitzen 46 zu unterbinden. Dies kann dadurch geschehen, dass die Datenverarbeitungseinrichtung bei Überschreiten des ersten Schwellwerts 42 ein Signal an die Steuereinheit des Gargeräts 10 übermittelt, die daraufhin den Mikrowellenbetrieb unterbricht, bis die Störung beseitigt ist.

Ergibt die Prognose dagegen eine zu erwartende dauerhafte Überschreitung des zulässigen Grenzwerts, wie in Fig. 2 gezeigt, kann schon vor Überschreitung des ersten Schwellwerts, beispielsweise zu Beginn des dritten Zeitintervalls 40, der Nutzer von der zu erwartenden Überschreitung und dem errechneten Ausfallzeitpunkt durch Anzeigen einer entsprechenden Nachricht auf dem Bedienfeld des Gargeräts in Kenntnis gesetzt werden. Der Nutzer kann sich frühzeitig auf den zu erwartenden Ausfall einstellen und Gegenmaßnahmen einleiten, beispielsweise einen Wartungstermin mit einem Kundendienst vereinbaren. Dadurch wird einem für den Nutzer überraschenden Ausfall des Gargeräts 10 wirkungsvoll vorgebeugt.

Über eine mit der Datenverarbeitungseinrichtung verbundene Datenübertragungseinrichtung kann der Kundendienst alternativ oder zusätzlich auch direkt und unmittelbar über die zu erwartenden Schwellwertüberschreitung und den prognostizierten Ausfallzeitpunkt informiert werden und sich daraufhin mit dem Nutzer zur Vereinbarung eines Wartungstermins in Verbindung setzen. Die Fernüberwachung bietet den zusätzlichen Vorteil, dass der Kundendienst den Erfolg der Wartung durch Auswertung des nachfolgenden Verlaufs der Mikrowellen-Leckagestrahlung kontrollieren und, sofern erforderlich, eine weitere Wartung initiieren kann.

Die detaillierte Beschreibung einer bevorzugten Ausführungsform und die zugehörigen Zeichnungen dienen ausschließlich der Illustration des erfindungsgemäßen Verfahrens und der erfindungsgemäßen Vorrichtung zur Mikrowellen-Leckageüberwachung. Der Schutzumfang der vorliegenden Erfindung ergibt sich allein aus den nachfolgenden Ansprüchen.

**Bezugszeichen**
- 10: Gargerät mit Mikrowellenfunktion
- 12: Garraum
- 14: Bodenfläche
- 16: Seitenwände
- 18: Abdeckung
- 20: Gargeräteöffnung
- 22: Träger
- 24: Einschubleiste
- 26: Auskopplungsstellen
- 28: Mikrowellensensor
- 29: Abfluss
- 30: Türbeschlag
- 31: Lampenfassung
- 32: Zuluftöffnung oder Abluftöffnung
- 33: Dampfzuführöfnung
- 34: zeitlicher Verlauf der erfassten Mikrowellenstrahlung
- 35: Installationsraum
- 36: erstes Zeitintervall
- 38: Prognosezeitintervall
- 40: drittes Zeitintervall
- 41: Vorwarnschwelle
- 42: erster Schwellwert
- 44: Kontrollintervall
- 46: Leckagespitze
- 48: Antenne
- 50: HF-Schaltung
- 52: Ausgang der HF-Schaltung 5

## Patentansprüche

1. Verfahren zur Mikrowellen-Leckageüberwachung bei einem Gargerät (10) mit Mikrowellenfunktion und einer Vorrichtung zur Mikrowellen-Leckageüberwachung, in dem eine Mikrowellen-Leckagestrahlung mittels einer Mikrowellen-Sensoreinrichtung (28) der Vorrichtung erfasst wird
der zeitliche Verlauf der erfassten Mikrowellenstrahlung für ein erstes Zeitintervall (36) mittels einer mit der Mikrowellen-Sensoreinrichtung (28) verbundenen Speichereinrichtung der Vorrichtung gespeichert wird; und
zumindest ein Teil der gespeicherten Mikrowellenstrahlungswerte von einer mit der Speichereinrichtung und/oder der Mikrowellen-Sensoreinrichtung (28) verbundenen Auswertungseinrichtung ausgewertet und/oder zur Auswertung ausgegeben wird.

2. Verfahren nach Anspruch 1, bei dem das erste Zeitintervall mindestens eine Woche, vorzugsweise mehr als fünf Wochen beträgt.

3. Verfahren nach Anspruch 1, bei dem die Mikrowellen-Leckagestrahlung im Bereich einer oder mehrerer Öffnungen (20) des Gargeräts (10) erfasst wird.

4. Verfahren nach einem der vorangehenden Ansprüche, bei dem die Mikrowellenstrahlung an mehreren Positionen unabhängig voneinander erfasst wird und ein Mittelwert oder ein Effektivwert mehrerer erfasster Mikrowellenstrahlungswerte gespeichert wird.

5. Verfahren nach einem der vorangehenden Ansprüche, wobei das Erfassen und/oder Speichern in vorbestimmten regelmäßigen zeitlichen Abständen oder in unregelmäßigen zeitlichen Abständen erfolgt, die ein vorbestimmtes zweites Zeitintervall nicht überschreiten.

6. Verfahren nach einem der vorangehenden Ansprüche, bei dem die Auswertung der Mikrowellenstrahlungswerte folgende Schritte umfasst:
Prognostizieren des zukünftigen zeitlichen Verlaufs der erfassten Mikrowellenstrahlung auf der Grundlage des gespeicherten zeitlichen Verlaufs (34) der erfassten Mikrowellenstrahlung;
Vergleichen des prognostizierten zeitlichen Verlaufs der erfassten Mikrowellenstrahlung mit einem vorbestimmten ersten Schwellwert (42); und
Ausgeben eines Signals, das mit einer auf der Grundlage des prognostizierten Verlaufs erwarteten Überschreitung des ersten Schwellwerts (42) assoziiert ist.

7. Verfahren nach Anspruch 6, bei dem der zukünftige zeitliche Verlauf der erfassten Mikrowellenstrahlung mittels einer Extrapolation oder Trendanalyse prognostiziert wird.

8. Verfahren nach Anspruch 6 oder 7, bei dem ein Signal ausgegeben wird, wenn der prognostizierte zeitliche Verlauf die Überschreitung des ersten Schwellwerts (42) innerhalb eines vorbestimmten dritten Zeitintervalls (40) erwarten lässt.

9. Verfahren nach einem der Ansprüche 6 bis 8, bei dem das ausgegebene Signal den aktuellen Wert der erfassten Mikrowellenstrahlung und/oder den gespeicherten zeitlichen Verlauf (34) der erfassten Mikrowellenstrahlung und/oder den prognostizierten zeitlichen Verlauf der Mikrowellenstrahlung und/oder den prognostizierten Zeitpunkt der Überschreitung des ersten Schwellwerts repräsentiert.

10. Verfahren nach einem der Ansprüche 6 bis 9, bei dem das Signal an ein mit dem Gargerät verbundenes Anzeigegerät und/oder eine mit dem Gargerät (10) verbundene Steuereinheit ausgegeben wird und/oder mittels einer Datenverbindung an eine entfernte Überwachungseinrichtung übermittelt wird.

11. Verfahren nach einem der Ansprüche 6 bis 10, bei dem ein Signal nur ausgegeben wird, wenn eines oder mehrere der folgenden Kriterien erfüllt ist:
- der prognostizierte zeitliche Verlauf überschreitet den ersten Schwellwert (42) für mindestens die Dauer eines vorbestimmten vierten Zeitintervalls,
- mehrere auf der Grundlage räumlich getrennter Sensoreinrichtungen prognostizierte Zeitverläufe der Mikrowellenstrahlung sagen eine Überschreitung des ersten Schwellwerts(42) vorher,
- mehrere auf der Grundlage von zu unterschiedlichen Zeitpunkten erfassten Mikrowellenstrahlungswerten prognostizierte Zeitverläufe der Mikrowellenstrahlung sagen eine Überschreitung des ersten Schwellwerts (42) vorher.

12. Gargerät mit Mikrowellenfunktion und einer vorrichtung zur Mikrowellen-Leckageüberwachung bei dem Gargerät (10), wobei die Vorrichtung Folgendes umfasst:
eine Mikrowellen-Sensoreinrichtung (28) mit zumindest einer Sensoreinheit, die zum Erfassen einer Mikrowellen-Leckagestrahlung geeignet ist;
eine Speichereinrichtung, die mit der Mikrowellen-Sensoreinrichtung (28) verbunden und zum Speichern des zeitlichen Verlaufs (34) der von der Mikrowellen-Sensoreinrichtung erfassten Mikrowellenstrahlung geeignet ist; und
eine Auswertungseinrichtung, die mit der Speichereinrichtung und/oder der Mikrowellen-Sensoreinrichtung (28) verbunden und dazu geeignet ist, zumindest einen Teil der in der Speichereinrichtung gespeicherten Mikrowellenstrahlungswerte auszuwerten und/oder zur Auswertung auszugeben.

13. Gargerät nach nach Anspruch 12, wobei die Auswertungseinrichtung eine Ausgabeeinheit umfasst, die zum Ausgeben des gespeicherten zeitlichen Verlaufs (34) der erfassten Mikrowellenstrahlung in regelmäßigen zeitlichen Abständen und/oder auf Anforderung eines Nutzers geeignet ist, und/oder eine Datenübertragungseinrichtung umfasst, die zum Übertragen eines Signals, das auf dem gespeicherten zeitlichen Verlauf der erfassten Mikrowellenstrahlung basiert, an eine räumlich vom Gargerät entfernte Überwachungseinrichtung geeignet ist.

14. Gargerät nach Anspruch 12 oder 13, wobei die Auswertungseinrichtung eine Datenverarbeitungseinrichtung umfasst, die dazu geeignet ist, auf der Grundlage der in der Speichereinrichtung gespeicherten Mikrowellenstrahlungswerte einen prognostizierten zeitlichen Verlauf der Mikrowellenstrahlung zu errechnen, den prognostizierten zeitlichen Verlauf mit einem vorbestimmten ersten Schwellwert (42) zu vergleichen und eine auf der Grundlage des prognostizierten Verlaufs erwartete Überschreitung des vorbestimmten ersten Schwellwerts (42) zu signalisieren.

15. Gargerät (10) nach einem der Ansprüche 12 bis 14, wobei eine oder mehrere Sensoreinheiten in oder an einer Geräteöffnung (20) des Gargeräts, insbesondere im Bereich einer Tür, eines Deckels, eines Abflusses (29), einer Lampenfassung (31), einer Zuluftöffnung (32), einer Abluftöffnung, einer Dampfzuführöffnung (33) und/oder einer Tür oder Deckel des Gargeräts und/oder einem Gehäuseabschnitt (35) angeordnet sind, in dem sich elektronische Bauteile des Gargerätes befinden.

## Claims

1. A method for microwave leakage monitoring of a cooking device (10) with a microwave function and a device for microwave leakage monitoring, in which a microwave leakage radiation is recorded using a microwave sensor facility (28) of the device, wherein
the time progression of the recorded microwave radiation for a first time interval (36) is stored using a storage facility of the device which is connected to the microwave sensor facility (28); and
at least a part of the stored microwave radiation values is evaluated and/or issued for evaluation by an evaluation facility which is connected to the storage facility and/or to the microwave sensor facility (28).

2. A method according to claim 1, wherein the first time interval is at least one week, and preferably more than five weeks.

3. A method according to claim 1, wherein the microwave leakage radiation is recorded in the area of one or more openings (20) of the cooking device (10).

4. A method according to any one of the preceding claims, wherein the microwave radiation is recorded at several positions independently from each other, and an average value or an effective value of several recorded microwave radiation values is stored.

5. A method according to any one of the preceding claims, wherein the recording and/or storage is conducted at prespecified regular time intervals or at irregular time intervals which do not exceed a prespecified second time interval.

6. A method according to any one of the preceding claims, wherein the evaluation of the microwave radiation values comprises the following steps:
Prognosis of the future time progression of the recorded microwave radiation on the basis of the stored time progression (34) of the recorded microwave radiation;
Comparison of the forecast time progression of the recorded microwave radiation with a prespecified first threshold value (42); and
Emission of a signal which is associated with the anticipated exceeding of the first threshold value (42) on the basis of the forecast progression.

7. A method according to claim 6, wherein the future time progression of the recorded microwave radiation is forecast using extrapolation or trend analysis.

8. A method according to either of claims 6 or 7, wherein a signal is issued when as a result of the forecast time progression, the exceeding of the first threshold value (42) can be anticipated within a prespecified third time interval (40).

9. A method according to any one of claims 6 to 8, wherein the signal issued represents the current value of the recorded microwave radiation and/or the stored time progression (34) of the recorded microwave radiation and/or the forecast time progression of the microwave radiation and/or the forecast time point of the exceeding of the first threshold value.

10. A method according to any one of claims 6 to 9, wherein the signal is issued to a display device which is connected to the cooking device and/or to a control unit which is connected to the cooking device (10) and/or is transmitted via a data connection to a remote monitoring facility.

11. A method according to any one of claims 6 to 10, wherein the signal is only issued when one or more of the following criteria are fulfilled:
- The forecast time progression exceeds the first threshold value (42) for at least the duration of a prespecified fourth time interval
- Several forecast time progressions of the microwave radiation on the basis of sensor facilities which are spatially separated anticipate an exceeding of the first threshold value (42)
- Several forecast time progressions of the microwave radiation on the basis of microwave radiation values recorded at different time points anticipate an exceeding of the first threshold value (42).

12. A cooking device with microwave function and a device for microwave leakage monitoring of the cooking device (10), wherein the device comprises the following:
A microwave sensor facility (28) with at least one sensor unit which is suitable for recording a microwave leakage radiation;
A storage device which is connected to the microwave sensor facility (28) and which is suitable for storing the time progression (34) of the microwave radiation recorded by the microwave sensor facility; and
An evaluation facility which is connected to the storage facility and/or to the microwave sensor facility (28), and which is suitable for evaluating at least a part of the microwave radiation values which are stored in the storage facility and/or for issuing them for evaluation.

13. A cooking device according to claim 12, wherein the evaluation facility comprises an issuing unit which is suitable for issuing the stored time progression (34) of the recorded microwave radiation at regular time intervals and/or at the request of the user, and/or comprises a data transmission facility which is suitable for transmitting a signal which is based on the stored time progression of the recorded microwave radiation to a monitoring facility which is at a spatial distance from the cooking device.

14. A cooking device according to either of claims 12 or 13, wherein the evaluation facility comprises a data processing facility which is suitable for calculating a forecast time progression on the basis of the microwave radiation values stored in the storage facility, to compare the forecast time progression with a prespecified first threshold value (42), and to indicate an anticipated exceeding of the prespecified first threshold value (42) on the basis of the forecast progression.

15. A cooking device according to any one of claims 12 to 14, wherein one or more sensor units are arranged in or on a device opening (20) of the cooking device, in particular in the area of the door, a lid, an outlet (29), a lamp fitting (31), a supply air opening (32), an extracted air opening, a steam feed opening (33) and/or a door or lid of the cooking device and/or a housing section (35), in which electronic components of the cooking device are located.

## Revendications

1. Procédé de surveillance de fuite de micro-ondes pour un appareil de cuisson (10) avec une fonction micro-ondes et un appareil destiné à la surveillance de fuite de micro-ondes, dans lequel un rayonnement de fuite de micro-ondes est détecté au moyen d'un dispositif formant capteur de micro-ondes (28) de l'appareil,
le déroulement temporel du rayonnement micro-ondes détecté est mémorisé pour un premier intervalle de temps (36) au moyen d'un dispositif de mémorisation relié au dispositif formant capteur de micro-ondes (28) ; et
au moins une partie des valeurs de rayonnement micro-ondes mémorisées est interprétée par un dispositif d'interprétation relié avec le dispositif de mémorisation et/ou le dispositif formant capteur de micro-ondes (28), et/ou émis en vue d'une interprétation.

2. Procédé selon la revendication 1, dans lequel le premier intervalle de temps est d'au moins une semaine, de préférence plus de 5 semaines.

3. Procédé selon la revendication 1, dans lequel le rayonnement de fuite de micro-ondes est détecté dans le secteur d'une ou plusieurs ouvertures (20) de l'appareil de cuisson (10).

4. Procédé selon l'une quelconque des revendications précédentes, dans lequel le rayonnement micro-ondes est détecté au niveau de plusieurs positions indépendantes les unes des autres et une valeur moyenne ou une valeur effective de plusieurs valeurs de rayonnement micro-ondes détectées est mémorisée.

5. Procédé selon l'une quelconque des revendications précédentes, dans lequel la détection et/ou la mémorisation a lieu à des intervalles temporels réguliers prédéterminés ou à des intervalles temporels irréguliers, qui ne dépassent pas un deuxième intervalle temporel prédéterminé.

6. Procédé selon l'une quelconque des revendications précédentes, dans lequel l'interprétation des valeurs de rayonnement micro-ondes comprend les étapes suivantes:
pronostiquer le déroulement temporel futur du rayonnement micro-ondes détecté sur la base du déroulement temporel mémorisé (34) du rayonnement micro-ondes détecté ;
comparer le déroulement temporel pronostiqué du rayonnement micro-ondes détecté avec une première valeur de seuil (42) prédéterminée ; et
émettre un signal qui est associé à un dépassement, attendu sur la base du déroulement pronostiqué, de la première valeur de seuil (42).

7. Procédé selon la revendication 6, dans lequel le déroulement temporel futur du rayonnement micro-ondes détecté est pronostiqué au moyen d'une extrapolation ou d'une analyse de tendance.

8. Procédé selon la revendication 6 ou 7, dans lequel un signal est émis lorsque le déroulement temporel pronostiqué laisse présager le dépassement de la première valeur de seuil (42) au sein d'un troisième intervalle de temps (40) prédéterminé.

9. Procédé selon l'une quelconque des revendications 6 à 8, dans lequel le signal émis représente la valeur actuelle du rayonnement micro-ondes détecté et/ou le déroulement temporel (34) mémorisé du rayonnement micro-ondes détecté et/ou le déroulement temporel pronostiqué du rayonnement micro-ondes et/ou l'instant pronostiqué du dépassement de la première valeur de seuil.

10. Procédé selon l'une quelconque des revendications 6 à 9, dans lequel le signal est émis au niveau d'un appareil d'affichage relié à l'appareil de cuisson et/ou d'une unité de commande reliée à l'appareil de cuisson (10) et/ou est transmis au moyen d'une liaison de données à un dispositif de surveillance distant.

11. Procédé selon l'une quelconque des revendications 6 à 10, dans lequel un signal n'est émis que lorsqu'un ou plusieurs des critères suivants sont remplis :
- le déroulement temporel pronostiqué dépasse la première valeur de seuil (42) pour au moins la durée d'un quatrième intervalle de temps prédéterminé,
- plusieurs déroulements temporels du rayonnement micro-ondes, pronostiqués sur la base des dispositifs formant capteur spatialement séparés, prévoient un dépassement de la première valeur de seuil (42),
- plusieurs déroulements temporels du rayonnement micro-ondes, pronostiqués sur la base de valeurs de rayonnement micro-ondes détectées à différents instants, prévoient un dépassement de la première valeur de seuil (42).

12. Appareil de cuisson avec une fonction micro-ondes et un appareil destiné à la surveillance de fuite de micro-ondes au sein de l'appareil de cuisson (10), dans lequel l'appareil comprend ce qui suit :
un dispositif formant capteur de micro-ondes (28) avec au moins une unité de capteur, qui est approprié pour la détection d'un rayonnement de fuite de micro-ondes ;
un dispositif de mémorisation, qui est relié avec le dispositif formant capteur de micro-ondes (28) et qui est approprié pour la mémorisation du déroulement temporel (34) du rayonnement micro-ondes détecté par le dispositif formant capteur de micro-ondes ; et
un dispositif d'interprétation, qui est relié avec le dispositif de mémorisation et/ou le dispositif formant capteur de micro-ondes (28) et qui est approprié pour interpréter et/ou émettre en vue d'une interprétation au moins une partie des valeurs de rayonnement de micro-ondes mémorisées dans le dispositif de mémorisation.

13. Appareil de cuisson selon la revendication 12, dans lequel le dispositif d'interprétation comprend une unité émettrice, qui est appropriée pour émettre le déroulement temporel mémorisé (34) du rayonnement micro-ondes détecté à des intervalles temporels réguliers et/ou sur demande d'un utilisateur, et/ou comprend un dispositif de transmission de données, qui est approprié pour transmettre un signal, basé sur le déroulement temporel mémorisé du rayonnement micro-ondes détecté, à un dispositif de surveillance spatialement distant de l'appareil de cuisson.

14. Appareil de cuisson selon la revendication 12 ou 13, dans lequel le dispositif d'interprétation comprend un dispositif de traitement des données, qui est approprié pour calculer un déroulement temporel pronostiqué du rayonnement micro-ondes sur la base des valeurs de rayonnement micro-ondes mémorisées dans le dispositif de mémorisation, pour comparer le déroulement temporel pronostiqué avec une première valeur de seuil (42) prédéterminée et pour signaler un dépassement, attendu sur la base du déroulement pronostiqué, de la première valeur de seuil (42) prédéterminée.

15. Appareil de cuisson (10) selon l'une quelconque des revendications 12 à 14, dans lequel une ou plusieurs unités de capteur sont agencées dans ou au niveau d'une ouverture d'appareil (20) de l'appareil de cuisson, en particulier dans le secteur d'une porte, d'un capot, d'un écoulement (29), d'une douille de lampe (31), d'une arrivée d'air, d'une ouverture d'admission de vapeur (33) et/ou d'une porte ou d'un capot de l'appareil de cuisson et/ou d'un panneau de boîtier (35), dans lequel se trouvent des composants électroniques de l'appareil de cuisson.
